(19) Europäisches Patentamt
European Patent Office
Office européen des brevets

(11) EP 2 767 841 A1

(12) **EUROPEAN PATENT APPLICATION**
published in accordance with Art. 153(4) EPC

(43) Date of publication:
**20.08.2014 Bulletin 2014/34**

(21) Application number: **11874084.4**

(22) Date of filing: **13.10.2011**

(51) Int Cl.:
***G01R 31/36*** *(2006.01)*

(86) International application number:
**PCT/JP2011/073529**

(87) International publication number:
**WO 2013/054414 (18.04.2013 Gazette 2013/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(71) Applicant: **TOYOTA JIDOSHA KABUSHIKI KAISHA**
**Toyota-shi, Aichi-ken, 471-8571 (JP)**

(72) Inventors:
- **KIMURA, Masaru**
  **Toyota-shi, Aichi-ken, 471-8571 (JP)**
- **MANO, Ryo**
  **Toyota-shi, Aichi-ken, 471-8571 (JP)**

(74) Representative: **Kuhnen & Wacker**
**Patent- und Rechtsanwaltsbüro**
**Prinz-Ludwig-Straße 40A**
**85354 Freising (DE)**

# (54) SECONDARY BATTERY CONTROL DEVICE AND METHOD

(57) From time (t1) at which an IG switch is turned off, charging/discharging of a secondary battery is stopped. Polarization cancellation time (Tr) required for cancelling polarization after stopping charging/discharging is changed in accordance with a temperature of the secondary battery. Until an elapse of a predetermined time corresponding to polarization cancellation time (Tr) from the time of turning off the IG switch, the battery voltage is detected cyclically, and an open circuit voltage is sequentially estimated in the equilibrium state in which the polarization is cancelled based on a shift of the battery voltage. In a case where the IG switch is turned on after an elapse of the predetermined time from the time of turning off the IG switch, a detection value of the battery voltage at the time of IG-on is assumed to be the open circuit voltage, and then the SOC at the time of starting use of the secondary battery is estimated. In a case where the IG switch is turned on before an elapse of the predetermined time from the time of turning off the IG switch, the estimated value of the opening circuit voltage at that time point is regarded as the open circuit voltage, and the SOC at the time of starting use of the secondary battery is estimated.

FIG.3

VOLTAGE
Tr
TIME
t1
(IG-OFF)
t2
t3



Printed by Jouve, 75001 PARIS (FR)

**Description**

TECHNICAL FIELD

The present invention relates to a control device and a control method for a secondary battery, and more particularly to estimation of a state of charge (SOC) of a secondary battery.

BACKGROUND ART

Generally, an automobile is provided with a rechargeable secondary battery as a power supply for a load. Particularly, in electrically-powered vehicles such as an electric vehicle, a hybrid vehicle, a fuel cell vehicle, and the like provided with a vehicle-driving motor, an SOC of the secondary battery as a power supply for an electric motor affects a cruisable distance of the vehicle. Thus, accurate estimation of the SOC is important.

Japanese Patent Laying-Open No. 2008-167622 (PTD 1) discloses that an SOC is calculated at the time of activating a vehicle (at the time of starting use of a battery) based on an open circuit voltage of a battery. Further, PTD 1 discloses that the SOC calculated at the time of stopping the vehicle (at the time of stopping use of the battery) is stored, and either the SOC based on the open circuit voltage of the battery measured at the time of activating the vehicle or the SOC calculated at the time of stopping the vehicle is selectively used as an initial value of the SOC according to conditions.

As disclosed in PTD 1, as a characteristic of a secondary battery, there has been known a phenomenon of causing a dynamic change in an output voltage depending on a charging/discharging history. For example, continuous discharging lowers the output voltage, and continuous charging raises the output voltage. Such a phenomenon is also referred to as "polarization." It is considered that the polarization is caused by a lack of balance in a chemical change at the time of charging/discharging between a vicinity of a surface of an electrode active material and an inner part of the material provided in the battery.

Japanese Patent Laying-Open No. 2008-191103 (PTD 2) and Japanese Patent Laying-Open No. 2008-82887 (PTD 3) disclose methods for predicting an open circuit voltage in an equilibrium state upon cancellation of the polarization by referring to a shift in a measured value of the battery voltage when a current does not flow.

Japanese Patent Laying-Open No. 2003-243045 (PTD 4) and Japanese Patent Laying-Open No. 2008-145199 (PTD 5) disclose that an SOC of a secondary battery connected to an auxiliary electric part and an engine is estimated based on a detected open circuit voltage.

CITATION LIST

PATENT DOCUMENT

PTD 1: Japanese Patent Laying-Open No. 2008-167622
PTD 2: Japanese Patent Laying-Open No. 2008-191103
PTD 3: Japanese Patent Laying-Open No. 2008-82887
PTD 4: Japanese Patent Laying-Open No. 2003-243045
PTD 5: Japanese Patent Laying-Open No. 2008-145199

SUMMARY OF INVENTION

TECHNICAL PROBLEM

In a case where driving of a vehicle is stopped, and thereafter next driving of the vehicle is started in a short period of time, an output voltage given at the time of activating the vehicle tends to be detected as an open circuit voltage before polarization is cancelled. When the SOC is estimated based on the open circuit voltage detected in such a manner, there is a concern that an estimation error in the SOC may occur by the amount of the polarization voltage.

According to PTD 2 and PTD 3, a shift in the output voltage from termination of use of the secondary battery is measured to predict an open circuit voltage in an equilibrium state where the polarization is cancelled. Such a manner of predicting an open circuit voltage suppresses an error due to the polarization voltage and enables estimation of the SOC at the time of starting use of the secondary battery. However, since it is necessary to activate the control device intermittently to measure the open circuit voltage and perform prediction calculation periodically, it is concerned that unnecessary power consumption during non-use of the secondary battery (when the vehicle is stopped) becomes greater.

The present invention was made to solve the problems described above, and an object of the present invention is to reflect the characteristic of cancellation of the polarization in the secondary battery and estimate the SOC accurately at the time of starting use without increasing unnecessary power consumption.

SOLUTION TO PROBLEM

According to one aspect of the present invention, a control device for a secondary battery includes a timing unit, a setting unit, an open circuit voltage estimating unit, and an initial value correcting unit. The timing unit measures an elapsed time from termination of use of the secondary battery. The setting unit variably sets a first time corresponding to a required time from termination of use of the secondary battery to cancellation of polarization in accordance with a battery temperature detected by a detector provided on the secondary battery. The open circuit voltage estimating unit is configured to calculate an estimated value of an open circuit voltage in an equilibrium state of the secondary battery based on a shift in a battery voltage detected by the detector, for an elapsed time shorter than the first time during a non-use period of the secondary battery. The initial value correcting unit is configured to calculate an initial value of an SOC by identifying the battery voltage detected by the detector at the time of starting use of said secondary battery as the open circuit voltage in a case where the elapsed time is longer than the first time, and calculate an initial value of an SOC by identifying the estimated value given by the open circuit voltage estimating unit as the open circuit voltage in a case where the elapsed time is shorter than the first time, at the time of starting use of the secondary battery.

Preferably, the control device is intermittently activated at each predetermined cycle to operate the open circuit voltage estimating unit until the elapsed time reaches the first time. After the elapsed time reaches the first time, intermittent activation of the control device is stopped until use of the secondary battery is started.

Preferably, the control device for a secondary battery further includes an SOC estimating unit. The SOC estimating unit is configured to sequentially calculate an estimated value of the SOC based on integration of a battery current detected by the detector during use of the secondary battery.

According to another aspect of the present invention, a control method for a secondary battery includes the steps of obtaining an elapsed time from termination of use of a secondary battery, variably setting a first time corresponding to a required time from termination of use of the secondary battery to cancellation of polarization in accordance with a battery temperature (Tb) detected by a detector provided on the secondary battery, calculating an estimated value of an open circuit voltage in an equilibrium state of the secondary battery based on a shift in a battery voltage detected by the detector for an elapsed time shorter than the first time during a non-use period of the secondary battery, calculating an initial value of an SOC by identifying the battery voltage detected by the detector at the time of starting use of the secondary battery as the open circuit voltage in a case where the elapsed time is longer than the first time at the time of starting use of the secondary battery, and calculating an initial value of an SOC by identifying the estimated value as the open circuit voltage in a case where the elapsed time is shorter than the first time at the time of starting use of the secondary battery.

Preferably, the control method for a secondary battery further includes the steps of intermittently activating a control device at each predetermined cycle to perform the step of calculating an estimated value of the open circuit voltage until the elapsed time reaches the first time, and stopping intermittent activation of the control device after the elapsed time reaches the first time.

Preferably, the control method for a secondary battery further includes the step of sequentially calculating an estimated value of the SOC based on integration of a battery current detected by the detector during use of the secondary battery.

ADVANTAGEOUS EFFECTS OF INVENTION

According to the present invention, an SOC at the time of starting use of a secondary battery can be estimated accurately without increasing unnecessary power consumption during a non-use period of the secondary battery.

BRIEF DESCRIPTION OF DRAWINGS

Fig. 1 schematically represents a configuration of an electrically-powered vehicle provided with a control device for a secondary battery according to an embodiment of the present invention.

Fig. 2 is a schematic diagram representing a characteristic relationship between an open circuit voltage and an SOC of a secondary battery.

Fig. 3 is a schematic diagram for description of a polarization phenomenon of a secondary battery.

Fig. 4 is a functional block diagram for description of SOC estimation performed by a control device for a secondary battery according to the embodiment of the present invention.

Fig. 5 is a flowchart for description of a control process for the SOC estimation during use of the secondary battery.

Fig. 6 is a flowchart for description of a control process during a secondary battery non-use period.

Fig. 7 is a schematic diagram representing an estimation process for an open circuit voltage during the secondary battery non-use period

Fig. 8 is a schematic diagram representing an example of a map for setting an estimation process time with respect to a battery temperature.

Fig. 9 is a flowchart for description of an SOC correcting process at the time of starting use of the secondary battery.

## DESCRIPTION OF EMBODIMENT

Hereinafter, an embodiment of the present invention will be described in detail with reference to the drawings. It should be noted that, in the following, the same parts or corresponding parts in the drawings have the same reference numerals allotted, and description thereof will not be repeated in principle.

### (System Configuration Example)

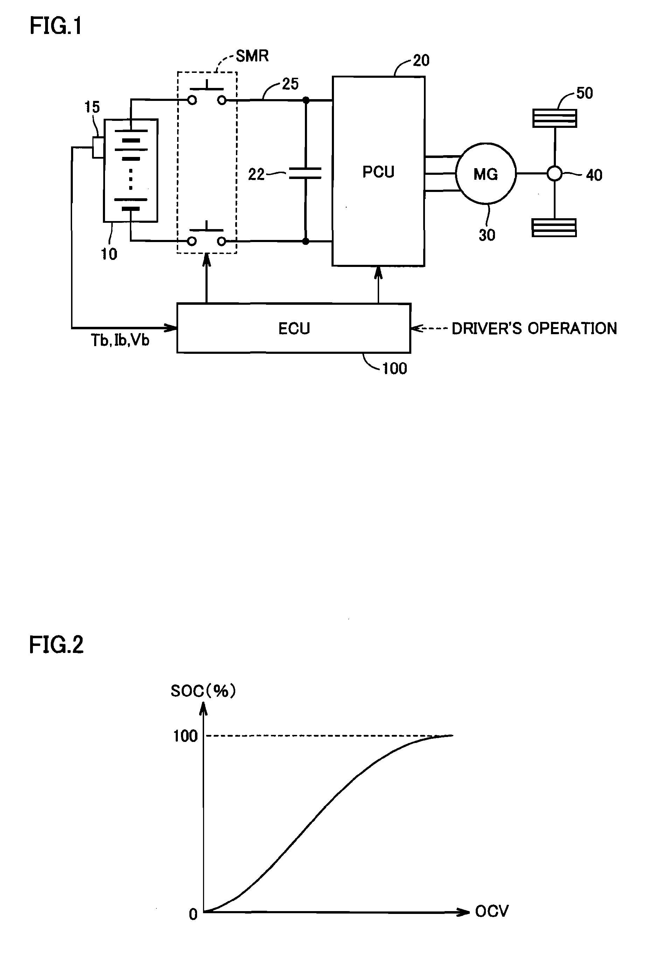

Fig. 1 schematically represents a configuration of an electrically-powered vehicle provided with a control device for a secondary battery according to an embodiment of the present invention.

Referring to Fig. 1, the electrically-powered vehicle includes a main battery 10, a power control unit (PCU) 20, a smoothing capacitor 22, a motor generator 30, a power transmission gear 40, drive wheels 50, and a control device 100.

Main battery 10 is composed of a "secondary battery" such as a lithium-ion battery, a nickel-metal hydride battery, or the like. Main battery 10 is provided with a battery sensor 15. Battery sensor 15 comprehensively represents a temperature sensor, a current sensor, a voltage sensor, and the like which are installed on main battery 10 but not illustrated in the drawings. Battery sensor 15 is configured to be capable of detecting a battery voltage Vb, a battery current Ib, and a battery temperature Tb.

PCU 20 converts stored power of main battery 10 to power for controlling driving of motor generator 30. For example, motor generator 30 is composed of a three-phase synchronous motor of a permanent magnet type, and PCU 20 is composed of a three-phase inverter. Alternatively, PCU 20 may be composed of a combination of a converter for variably controlling an output voltage from main battery 10 and a three-phase inverter for converting the output voltage of the converter to an alternate-current voltage.

A current flow path between main battery 10 and PCU 20 is connected with a system main relay SMR. System main relay SMR is turned on in response to an activation command of an electric system for the electrically-powered vehicle, for example, in response to turning an ignition switch (IG switch) on.

Turning on system main relay SMR allows use of main battery 10 (charging/discharging) to start. On the other hand, turning off system main relay SMR causes use of main battery 10 (charging/discharging) to terminate. During the off-period of system main relay SMR, charging/discharging of main battery 10 is stopped, and main battery 10 turns into non-use.

Main battery 10 is connected with a power line 25 of PCU 20 through system main relay SMR A smoothing capacitor 22 is connected to power line 25 and serves to smooth a direct-current voltage.

An output torque of motor generator 30 is transmitted to drive wheels 50 through power transmission gear 40 composed of a reducer, a power split mechanism, and the like to allow running of the electrically-powered vehicle.

Motor generator 30 can generate power with use of a rotational force of drive wheels 50 during a regenerative braking operation of the electrically-powered vehicle. The generated power is converted by PCU 20 to charging power for main battery 10.

In a hybrid vehicle provided with an engine (not illustrated) in addition to motor generator 30, a coordinate operation of the engine and motor generator 30 generates driving power required for the electrically-powered vehicle. At this time, main battery 10 can be charged with use of power generated by rotation of the engine. In other words, the electrically-powered vehicle represents a vehicle provided with an electric motor for generating vehicle driving power, and includes a hybrid vehicle which generates vehicle driving power with use of an engine and an electric motor, an electric vehicle not provided with an engine, a fuel cell vehicle, and the like.

Control device 100 controls equipment provided in the electrically-powered vehicle. Control device 100 is composed of an electronic control unit (ECU) provided therein with a CPU (Central Processing Unit) and a memory, which are not illustrated in the drawings. The ECU is configured to perform arithmetic processing with use of a detection value given by each sensor based on a map and a program stored in the memory. Alternatively, at least a part of the ECU may be configured to perform predetermined numerical/logical arithmetic processing with use of hardware such as an electronic circuit and the like.

In the configuration example of Fig. 1, control device 100 generates an on/off signal for system main relay SMR and a signal for controlling operation of PCU 20 so that the vehicle runs in response to operation of a driver. For example, in aim of allowing motor generator 30 to operate in accordance with an operation command (typically, a torque command value), control device 100 controls a power conversion operation in PCU 20, specifically, an on/off operation of a power semiconductor switching device constituting the inverter described above (not illustrated in the drawings) or the inverter and converter (not illustrated in the drawings).

Further, control device 100 estimates an SOC of main battery 10 based on battery data (a general term for Vb, Ib, and Tb) detected by battery sensor 15. Based on an SOC estimated value, an output of motor generator 30 is restricted as needed.

Generally, it has been known that a certain characteristic relationship as shown in Fig. 2 is present between an open circuit voltage (OCV) and an SOC of a secondary battery. Thus, if an open circuit voltage of the secondary battery can be detected accurately, an SOC can be estimated accurately.

However, an output voltage (battery voltage Vb) of the secondary battery includes a voltage change due to internal resistance and polarization. In other words, as shown in the following expression (1), a battery voltage Vb is represented by a sum of an open circuit voltage OCV, a polarization voltage Vdyn, and a voltage change given by a product of internal resistance R and battery current Ib.

$$Vb = OCV + Vdyn - Ib \cdot R \qquad \ldots(1)$$

Therefore, since the internal resistance and the polarization voltage cause a change in the output voltage of the secondary battery during the use of the secondary battery (during charging/discharging), it is difficult to accurately calculate the open circuit voltage from the detection value of battery voltage Vb. Thus, during the use of the secondary battery, the SOC change amount is generally estimated in accordance with an integrated value of battery current Ib to sequentially estimate the SOC. However, the SOC estimation through the current integration has a tendency to cause an estimation error due to a measurement error (offset and the like) of the current sensor.

Further, since battery current Ib=0 is provided after the use of the secondary battery is terminated, the voltage change due to the internal resistance does not appear. Therefore, it becomes easy to estimate the open circuit voltage based on battery voltage Vb. Therefore, at the time of starting use of the secondary battery, the SOC estimated value based on the current integration for the previous use can be corrected based on the open circuit voltage.

However, even during non-use of the secondary battery, there is a possibility that battery voltage Vb includes a polarization voltage. Therefore, if a detection value of battery voltage Vb is directly regarded as an open circuit voltage, there is a possibility that an error occurs in the SOC estimation.

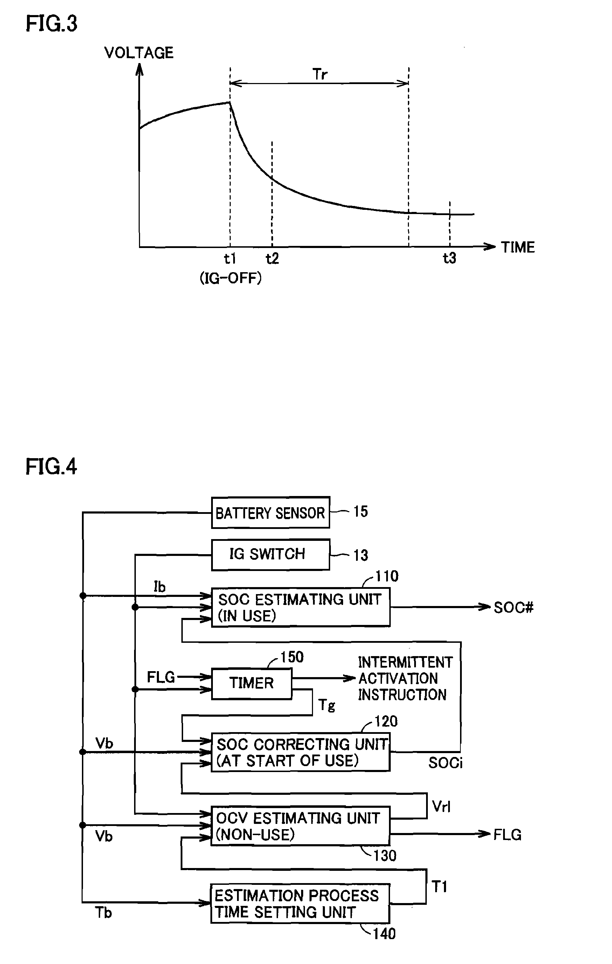

Fig. 3 represents an example of a shift in the battery voltage after termination of charging/discharging of main battery 10, in other words, during non-use of the secondary battery.

Referring to Fig. 3, at time t1, system main relay SMR is turned off in response to turning off the IG switch. Accordingly, the use of main battery 10 (charging/discharging) is terminated. Thus, on or after time t1, battery voltage Vb is detected in the state of battery current Ib=0.

At the time of termination of use of the secondary battery, battery voltage Vb includes the polarization voltage. In the example of Fig. 3, the polarization voltage occurs in the voltage rising direction. When the charging/discharging is stopped, the polarization is gradually cancelled with an elapse of time. The polarization voltage is reduced as the polarization is cancelled, so that battery voltage Vb is gradually lowered in the example of Fig. 3.

After an elapse of a predetermined time Tr, the polarization is cancelled, and the secondary battery attains an equilibrium state. Thus, battery voltage Vb after the elapse of Tr shows the open circuit voltage which does not include the polarization voltage. Hereinafter, time Tr required for cancellation of the polarization from the termination of use of the secondary battery will also be referred to as "polarization cancellation time."

Therefore, battery voltage Vb measured at time t3 after the elapse of Tr is used as the open circuit voltage (OCV), so that the SOC can be estimated accurately in accordance with the characteristic relationship shown in Fig. 2. On the other hand, when battery voltage Vb at time t2 prior to an elapse of Tr is regarded as the open circuit voltage, the SOC is estimated based on a voltage higher than the open circuit voltage in the equilibrium state. Accordingly, an estimation error of the SOC occurs.

As described above, it is important to take into consideration the polarization phenomenon to estimate the SOC based on the open circuit voltage at the time of starting use of the secondary battery. In the present embodiment, the change in the polarization cancellation time (Tr in Fig. 3) in accordance with the battery temperature is reflected to estimate the SOC of the secondary battery efficiently and accurately.

Fig. 4 is a functional block diagram for description of the SOC estimation performed by the control device for a secondary battery according to the embodiment of the present invention. Each functional block shown in Fig. 4 may be composed of a circuit (hardware) having a function corresponding to each block, or may be achieved by control device 100 executing software processing in accordance with a preset program.

Referring to Fig. 4, control device 100 includes an SOC estimating unit 110, an SOC correcting unit 120, an OCV estimating unit 130, an estimation process time setting unit 140, and a timer 150.

SOC correcting unit 120 operates at the time of turning on IG switch 13 (operation from off to on), in other words, at the time of starting use of the secondary battery. SOC correcting unit 120 calculates an SOC initial value (SOCi) at the time of starting use of main battery 10 based on battery voltage Vb which is detected by battery sensor 15 until charging/discharging of the secondary battery is started. SOC correcting unit 120 corresponds to the "initial value correcting unit."

SOC estimating unit 110 calculates an SOC estimated value (SOC#) of main battery 10 at a predetermined cycle based on battery current Ib which is detected by battery sensor 15 during an on-period (continuous period of an on-state) of IG switch 13. During the on-period of IG switch 13, system main relay SMR is turned on to perform charging/discharging of main battery 10. In other words, SOC estimating unit 110 operates during the use of the secondary battery.

OCV estimating unit 130 cyclically detects battery voltage Vb during the off-period (continuous period of the off-state) of IG switch 13 to calculate an estimated value Vrl of the open circuit voltage at the time of cancellation of the polarization (equilibrium state). OCV estimating unit 130 corresponds to the "open circuit voltage estimating unit."

Timer 150 measures an elapsed time Tg from the time of turning offIG switch 13 (operation from on to off) during the non-use period of the secondary battery. Timer 150 corresponds to the "timing unit." Timer 150 gives an intermittent activation instruction for performing the estimation process of OCV estimating unit 130 at each predetermined cycle. During the non-use period of the secondary battery, control device 100 basically is stopped or switched to a low-power mode (sleep mode) for the purpose of saving power consumption. However, control device 100 operates to perform a predetermined processing when the intermittent activation instruction is given.

Estimation process time setting unit 140 variably sets estimation process time T1 for allowing OCV estimating unit 130 to perform the estimation processing, in accordance with battery temperature Tb detected by battery sensor 15 during the non-use period of the secondary battery. Estimation process time T1 corresponds to the "first time."

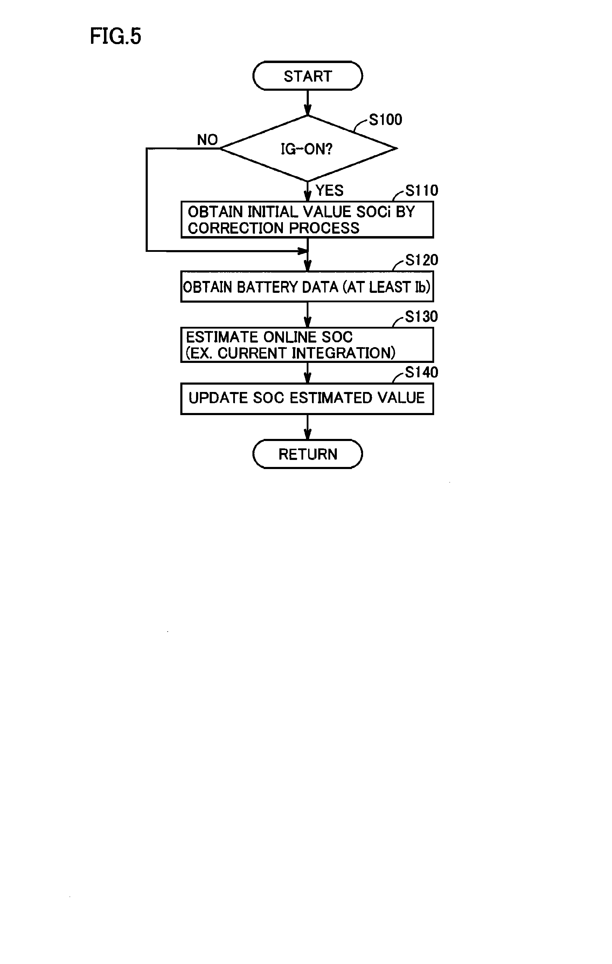

Fig. 5 is a flowchart for description of a control process for the SOC estimation during use of the secondary battery. The control process shown in Fig. 5 is performed at each predetermined cycle by control device 100. The process shown in Fig. 5 corresponds to the function of SOC estimating unit 110 shown in Fig. 4.

Referring to Fig. 5, in step S100, control device 100 determines whether or not IG switch 13 is turned on. Only the control cycle at which IG switch 13 is turned on is determined as YES in step S100, and other cases are determined as NO in step S100.

At the IG-on (at the time of determination of YES in S100), in step S110, control device 100 obtains an SOC initial value (SOCi) given by SOC correcting unit 120. When it is other than at the IG-on (determination of NO in S100), the processing in step S110 is skipped.

In step S120, control device 100 obtains battery data given by battery sensor 15. The battery data includes at least battery current Ib. Further, in step S130, control device 100 performs online SOC estimation based on the battery data. Typically, an SOC change amount ΔSOC at the cycle is calculated based on an integrated value of battery current Ib.

Further, in step S140, control device 100 updates the SOC estimated value based on the online estimation. Accordingly, a present SOC estimated value (SOC#) is calculated. In the SOC estimation based on the current integration, ΔSOC for each cycle is sequentially added starting from the SOC initial value (SOCi) during the on-state of the IG switch, so that the SOC estimated value (SOC#) is updated for each cycle.

The SOC estimation during the use of the secondary battery may be performed with a method different from the current integration. However, a combination of the current integration, which involves a simple calculation method, and the initial value correction process based on the open circuit voltage at the time of starting use can provide efficient estimation of the SOC of the secondary battery.

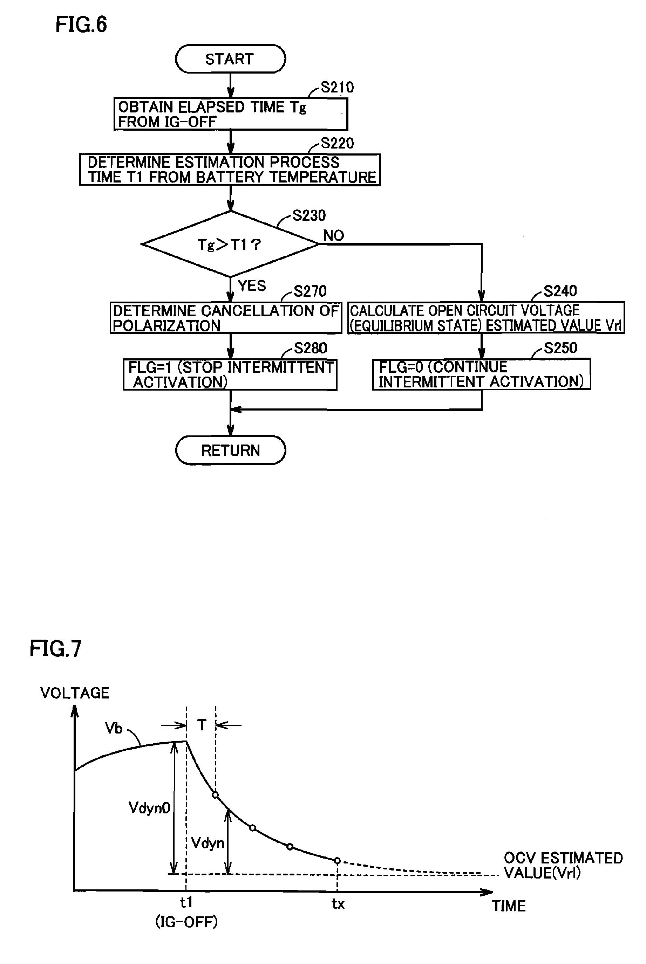

Next, referring to Fig. 6, the control process during the secondary battery non-use period will be described. The control process shown in Fig. 6 is performed at each predetermined cycle until the intermittent activation is stopped (during FLG=0). The process shown in Fig. 6 corresponds to the functions of OCV estimating unit 130, estimation process time setting unit 140, and timer 150, which are shown in Fig. 4.

In step S210, control device 100 obtains elapsed time Tg from the time of turning off of the IG switch based on an output of timer 150. Elapsed time Tg corresponds to an elapsed time from termination of charging/discharging of the secondary battery.

In step S220, control device 100 determines estimation process time T1 based on battery temperature Tb detected by battery sensor 15. Estimation process time T1 is set so as to correspond to polarization cancellation time Tr shown in Fig. 3.

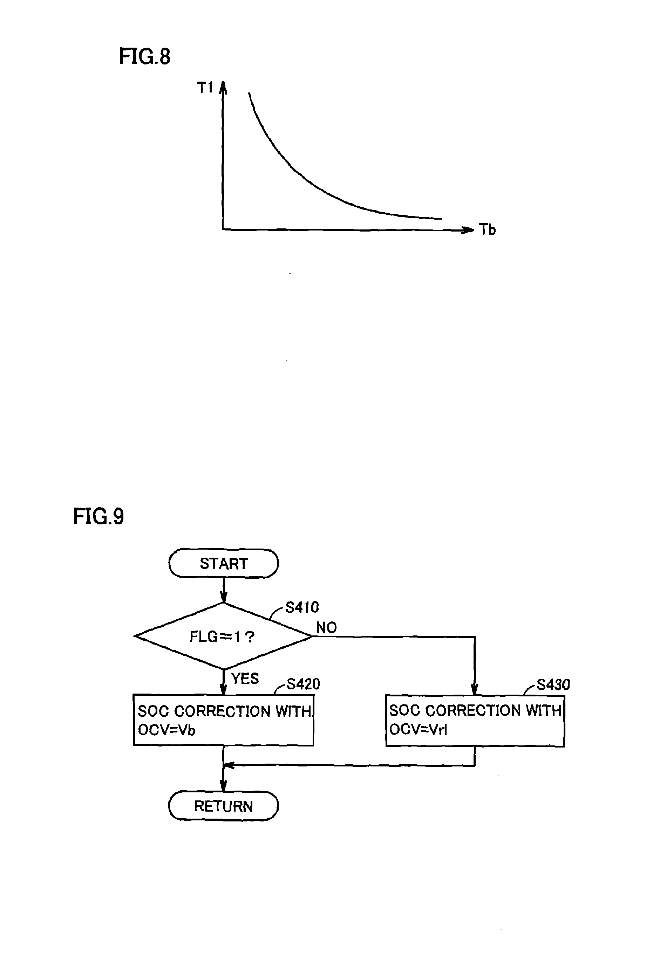

Polarization cancellation time Tr is changed in accordance with battery temperature Tb. Qualitatively, longer the time is required to cancel the polarization as the temperature is lower. In accordance with the temperature dependency of polarization cancellation time Tr calculated in advance based on a result of an on-site practical experiment and the like, a map like the one shown in Fig. 8 for calculating estimation process time T1 from battery temperature Tb can be created in advance.

In the most convenient manner, estimation process time T1 can be determined based on battery temperature Tb at the time of IG-off. In this case, step S220 is performed only at the time of IG-off. Alternatively, estimation process time T1 may be corrected so as to reflect a shift of battery temperature Tb from the IG-off.

Referring back to Fig. 6, in step S230, control device 100 compares elapsed time Tg with estimation process time T1. Control device 100 allows the process to proceed to steps S240 and S250 from the IG-off to an elapse of estimation process time T1 (determination of NO in S230).

In step S240, control device 100 calculates estimated value Vrl of the open circuit voltage in the equilibrium state based on a shift of battery voltage Vb after the IG-off (during non-use of the secondary battery). Further, in step S250, control device 100 maintains flag FLG=0 to continue the intermittent activation.

Fig. 7 schematically represents an estimation process for an open circuit voltage performed in step S240.

Referring to Fig. 7, after IG switch 13 is turned off at time t1, battery voltage Vb is measured at each predetermined cycle T. At the time of the IG-off, polarization voltage Vdyn=Vdyn0 (initial value) is provided. Polarization voltage Vdyn is damped exponentially in accordance with an elapse of time. Thus, the change in the polarization voltage at cycle T is approximated by the following expression (2). The "τ" in the expression (2) is a time constant of damping. Vdyn(t) represents the polarization voltage in the control cycle for the present time, and Vdyn(t-T) represents the polarization voltage in the previous control cycle.

$$Vdyn(t)=Vdyn(t-T)*(1/\exp(T/\tau)) \qquad \ldots(2)$$

Thus, in step S240, at each time battery voltage Vb is measured, the voltage change between cycles is assumed to be the change in polarization voltage Vdyn, so that time constant τ and Vdyn0 (initial value) can be estimated. Further, with use of an estimation result, estimated value Vrl of the open circuit voltage after an elapse of sufficient time and cancellation of the polarization can be calculated. For example, at time tx in Fig. 7, based on voltage detection values from time t1 to tx, estimated value Vr1 of the open circuit voltage (equilibrium state) can be calculated. The Vr1 is updated at each time the step S240 is performed.

Referring back to Fig. 6, after an elapse of estimation process time T1 from the IG-off (determination of YES in S230), control device 100 allows the process to proceed to step S270, and determines that the polarization is cancelled. Further, in step S280, control device 100 sets flag FLG=1 to stop subsequent intermittent activation. Accordingly, until the use of the secondary battery is started after IG switch 13 is turned on again, control device 100 maintains the stopped state.

Fig. 9 shows a flowchart for description of the SOC correcting process at the time of starting use of the secondary battery. The control process shown in Fig. 9 is performed at the time when IG switch 13 is turned on. The process of Fig. 9 achieves the function of SOC correcting unit 120 shown in Fig. 4.

Referring to Fig. 9, in step S410, control device 100 determines whether or not flag FLG=1 is provided. When FLG=1 is provided, estimation process time T1 has elapsed form the IG-off, thus it is determined that the polarization is cancelled during the IG-off (non-use period of the secondary battery). Thus, when FLG=1 is provided (determination of YES in S410), control device 100 in step S420 regards battery voltage Vb in the present state (at the IG-on) as open circuit voltage OCV and performs the SOC correction. In other words, referring to the characteristic relationship shown in Fig. 2, the SOC corresponding to battery voltage Vb at IG-on is used as an SOC initial value (SOCi).

On the other hand, when FLG=0 is provided, before estimation process time T1 elapses from the IG-off, in other words, before cancellation of the polarization, it can be determined that use of the secondary battery is started again. Thus, the SOC correction cannot be performed by directly regarding the battery voltage Vb at the IG-on as the open circuit voltage. However, as shown in Fig. 6, during the period of Tg<T1, estimated value Vrl of the open circuit voltage is calculated based on the latest detection value of battery voltage Vb.

Thus, when FLG=0 is provided (at the time of determination of NO in S410), in step S430, control device 100 performs the SOC correction regarding present estimated value Vrl of the open circuit voltage (equilibrium state) as open circuit voltage OCV. In other words, referring to the characteristic relationship shown in Fig. 2, the SOC corresponding to estimated value Vrl of the open circuit voltage is used as the SOC initial value (SOCi).

As described above, according to the control device and the control method for a secondary battery according to the embodiment of the present invention, influence of the polarization voltage can be removed to accurately estimate the SOC at the time of starting use of main battery 10 (secondary battery). Further, in accordance with the temperature dependency of the polarization cancellation time, the performance period of the estimation process of the opening circuit voltage can be suppressed appropriately and at minimum by changing estimation process time T1 in accordance with the battery temperature. Consequently, as compared to the case of uniformly setting estimation process time T1, unnecessary intermittent activation of control device 100 is stopped to thereby enabling suppression of power consumption.

In the present embodiment, a vehicle driving motor of an electrically-powered vehicle is illustrated as a load of the secondary battery. However, application of the present invention is not limited to such a configuration. In other words, as long as a configuration is provided which has a mechanism for starting/terminating use of the secondary battery, the present invention can be applied without particularly limiting the load.

It should be understood that embodiments disclosed herein are illustrative and not restrictive in every respect. The scope of the present invention is defined by the terms of the claims, rather than the description of the embodiments set forth above, and is intended to include any modifications within the scope and meaning equivalent to the terms of the claims.

## INDUSTRIAL APPLICABILITY

The present invention can be used for the SOC estimation of the secondary battery.

## REFERENCE SIGNS LIST

10 main battery; 13 IG switch; 15 battery sensor; 22 smoothing capacitor; 25 power line; 30 motor generator; 40 power transmission gear; 50 drive wheels; 100 control device; 110 SOC estimating unit; 120 SOC correcting unit; 130 OCV estimating unit; 140 estimation process time setting unit; 150 timer; FLG flag (elapse of T1); Ib battery current; OCV open circuit voltage; SMR system main relay; T cycle; T1 estimation process time; Tb battery temperature; Tg elapsed time (after IG-off); Tr polarization cancellation time; Vb battery voltage; Vdyn polarization voltage; Vrl open circuit voltage estimated value (equilibrium state).

## Claims

**1.** A control device for a secondary battery, comprising:

a timing unit (150) for measuring an elapsed time (Tg) from termination of use of a secondary battery (10);
a setting unit (140) for variably setting a first time (T1) corresponding to a required time from termination of use of said secondary battery to cancellation of polarization in accordance with a battery temperature (Tb) detected by a detector (15) provided on said secondary battery;
an open circuit voltage estimating unit (130) for calculating an estimated value of an open circuit voltage in an equilibrium state of said secondary battery based on a shift in a battery voltage (Vb) detected by said detector, for an elapsed time shorter than said first time during a non-use period of said secondary battery; and
an initial value correcting unit (120), at the time of starting use of said secondary battery, for calculating an initial value of an SOC (SOCi) by identifying said battery voltage detected by said detector at the time of starting use of said secondary battery as said open circuit voltage in a case where said elapsed time is longer than said first time, and for calculating the initial value of an SOC by identifying said estimated value given by said open circuit voltage estimating unit as said open circuit voltage in a case where said elapsed time is shorter than said first time.

**2.** The control device for a secondary battery according to claim 1, wherein said control device (100) is intermittently activated at each predetermined cycle (T) to operate said open circuit voltage estimating unit (130) until said elapsed time (Tg) reaches said first time (T1), and
after said elapsed time reaches said first time, intermittent activation of said control device is stopped until use of said secondary battery is started.

**3.** The control device for a secondary battery according to claim 1, further comprising an SOC estimating unit (110) for sequentially calculating an estimated value (SOC#) of said SOC based on integration of a battery current (Ib) detected by said detector (15) during use of said secondary battery (10).

**4.** A control method for a secondary battery, comprising the steps of:

obtaining (S210) an elapsed time (Tg) from termination of use of a secondary battery (10);
variably setting (S220) a first time (T1) corresponding to a required time from termination of use of said secondary battery to cancellation of polarization in accordance with a battery temperature (Tb) detected by a detector (15) provided on said secondary battery;
calculating (S240) an estimated value of an open circuit voltage in an equilibrium state of said secondary battery based on a shift in a battery voltage (Vb) detected by said detector for an elapsed time shorter than the first time during a non-use period of said secondary battery;
calculating (S420) an initial value (SOCi) of an SOC by identifying said battery voltage detected by said detector at the time of starting use of said secondary battery as said open circuit voltage in a case where said elapsed time is longer than said first time at the time of starting use of said secondary battery; and
calculating (S430) an initial value of an SOC by identifying said estimated value as said open circuit voltage in a case where said elapsed time is shorter than said first time at the time of starting use of said secondary battery.

**5.** The control method for a secondary battery according to claim 4, further comprising the steps of:

intermittently activating (S250) a control device (100) at each predetermined cycle (T) to perform the step of calculating (S240) an estimated value of said open circuit voltage until said elapsed time (Tg) reaches said first time (T1); and
stopping (S280) intermittent activation of said control device after said elapsed time reaches said first time.

**6.** The control method for a secondary battery according to claim 4, further comprising the step of:

sequentially calculating (S120 to S140) an estimated value of said SOC (SOC#) based on integration of a battery current (Ib) detected by said detector (15) during use of said secondary battery (10).

FIG.1

SMR
20
25
50
15
22
PCU
MG
40
30
10
ECU
DRIVER'S OPERATION
Tb, Ib, Vb
100

FIG.2

SOC(%)
100
0
OCV

FIG.3

VOLTAGE
Tr
TIME
t1
(IG-OFF)
t2
t3

FIG.4

BATTERY SENSOR
15
IG SWITCH
13
110
Ib
SOC ESTIMATING UNIT
(IN USE)
SOC#
150
FLG
TIMER
INTERMITTENT
ACTIVATION
INSTRUCTION
Tg
120
Vb
SOC CORRECTING UNIT
(AT START OF USE)
SOCi
Vrl
OCV ESTIMATING UNIT
(NON-USE)
Vb
FLG
130
T1
ESTIMATION PROCESS
TIME SETTING UNIT
Tb
140

FIG.5

START
S100
NO
IG-ON?
YES
S110
OBTAIN INITIAL VALUE SOCi BY CORRECTION PROCESS
S120
OBTAIN BATTERY DATA (AT LEAST Ib)
S130
ESTIMATE ONLINE SOC (EX. CURRENT INTEGRATION)
S140
UPDATE SOC ESTIMATED VALUE
RETURN

FIG.6

START
S210
OBTAIN ELAPSED TIME Tg FROM IG-OFF
S220
DETERMINE ESTIMATION PROCESS TIME T1 FROM BATTERY TEMPERATURE
S230
Tg>T1 ?
NO
YES
S270
DETERMINE CANCELLATION OF POLARIZATION
S240
CALCULATE OPEN CIRCUIT VOLTAGE (EQUILIBRIUM STATE) ESTIMATED VALUE Vrl
S280
FLG=1 (STOP INTERMITTENT ACTIVATION)
S250
FLG=0 (CONTINUE INTERMITTENT ACTIVATION)
RETURN

FIG.7

VOLTAGE
Vb
T
Vdyn0
Vdyn
OCV ESTIMATED VALUE(Vrl)
t1
(IG-OFF)
tx
TIME

FIG.8

T1

Tb

FIG.9

START
S410
FLG=1?
NO
YES
S420
SOC CORRECTION WITH OCV=Vb
S430
SOC CORRECTION WITH OCV=Vrl
RETURN

**INTERNATIONAL SEARCH REPORT**

International application No.
PCT/JP2011/073529

A. CLASSIFICATION OF SUBJECT MATTER
*G01R31/36*(2006.01)i

According to International Patent Classification (IPC) or to both national classification and IPC

B. FIELDS SEARCHED

Minimum documentation searched (classification system followed by classification symbols)
G01R31/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2008/082010 A1 (TOYOTA JIDOSHA KABUSHIKI KAISHA), 10 July 2008 (10.07.2008), & CN 101573628 A & EP 2101183 A1 & JP 2008-167622 A & JP 4687654 B2 & US 2010/0010707 A1 | 1-6 |
| Y | WO 2011/122164 A1 (FURUKAWA ELECTRIC CO., LTD.), 06 October 2011 (06.10.2011), & JP 2011-209237 A | 1-6 |
| Y | JP 2008-191103 A (Autonetworks Technologies, Ltd.), 21 August 2008 (21.08.2008), (Family: none) | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 December, 2011 (22.12.11) | 10 January, 2012 (10.01.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/073529

C (Continuation). DOCUMENTS CONSIDERED TO BE RELEVANT

| Category* | Citation of document, with indication, where appropriate, of the relevant passages | Relevant to claim No. |
|---|---|---|
| A | JP 2008-82887 A (Autonetworks Technologies, Ltd.), 10 April 2008 (10.04.2008), (Family: none) | 1-6 |
| A | US 2003/0097225 A1 (Teruo ISHISHITA), 22 May 2003 (22.05.2003), & JP 2003-149307 A & JP 2003-243045 A & JP 3778060 B2 & JP 4078847 B2 & US 6845332 B2 | 1-6 |
| A | JP 2008-145199 A (Autonetworks Technologies, Ltd.), 26 June 2008 (26.06.2008), (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008167622 A
- JP 2008191103 A
- JP 2008082887 A
- JP 2003243045 A
- JP 2008145199 A